**Europäisches Patentamt**

**European Patent Office**

**Office européen des brevets**

(11) Numéro de publication: **0 133 387**
**B1**

## FASCICULE DE BREVET EUROPEEN

(45) Date de publication du fascicule du brevet:
**22.06.88**

(51) Int. Cl.⁴: **H 03 H 19/00**

(21) Numéro de dépôt: **84401337.5**

(22) Date de dépôt: **26.06.84**

(54) Filtre à capacités commutées à structure répétitive.

(30) Priorité: **04.07.83 FR 8311075**

(43) Date de publication de la demande:
**20.02.85 Bulletin 85/8**

(45) Mention de la délivrance du brevet:
**22.06.88 Bulletin 88/25**

(84) Etats contractants désignés:
**DE FR GB IT NL**

(56) Documents cités:
**ELECTRICAL DESIGN NEWS, vol. 28, no. 4, février 1983, pages 45-48, Boston, US; W. TWADDELL: "Switched-capacitor-array introductions herald semicustom analog flexibility"**

(73) Titulaire: **SGS-THOMSON MICROELECTRONICS S.A., 101, bld Murat, F-75016 Paris (FR)**

(72) Inventeur: **Caillon, Christian, THOMSON-CSF SCPI 173, bld Haussmann, F-75379 Paris Cedex 08 (FR)**
Inventeur: **Fensch, Thierry, THOMSON-CSF SCPI 173, bld Haussmann, F-75379 Paris Cedex 08 (FR)**
Inventeur: **Terrier, Christian, THOMSON-CSF SCPI 173, bld Haussmann, F-75379 Paris Cedex 08 (FR)**

(74) Mandataire: **Guérin, Michel et al, THOMSON-CSF SCPI 19, avenue de Messine, F-75008 Paris (FR)**

## Description

La présente invention concerne les filtres à capacités commutées réalisés en circuits intégrés.

Les filtres à capacités commutées sont des circuits électriques relativement complexes, incorporant un grand nombre d'éléments (amplificateurs, interrupteurs et capacités notamment). Ils sont destinés à établir, entre une entrée de signal électrique et une sortie de signal, une fonction de transfert bien déterminée qui peut être par exemple une fonction passe-bas ou passe-haut ou passe-bande, etc.

Chaque modification de fonction de transfert entraîne une modification importante du circuit, aussi bien dans les valeurs numériques attachées à ce circuit (fréquence d'échantillonnage, valeurs des capacités du circuit), que dans la structure même du circuit (couplages entre amplificateurs, etc.).

On est par conséquent amené, à chaque fois que l'on a besoin d'un filtre de caractéristiques bien déterminées, à concevoir une structure de filtre répondant à ces caractéristiques et à affecter des valeurs numériques particulières notamment aux capacités du circuit. Après l'établissement du schéma et des valeurs de capacités correspondant aux besoins, il faut réaliser un circuit intégré correspondant et donc concevoir comment on va placer sur la surface d'un substrat semiconducteur les divers éléments de circuit. Cette dernière opération est particulièrement longue et coûteuse; elle entraîne des délais de fabrication importants, alors que le circuit peut répondre à un besoin urgent d'un utilisateur.

On pourra se reporter à un exemple d'art antérieur qui concerne un circuit intégré de filtrage à capacités commutées constitué de cellules réliées en cascades et qui a été décrit dans l'article d'Electrical Design News de février 1983, pages 45–48.

La présente invention propose un filtre de structure pariculière qui permet de réduire considérablement les coûts et délais de fabrication, et pour cela elle propose d'une part de rejeter à une étape finale de la fabrication non seulement les modifications de valeur numériques, mais aussi les modifications de structure du circuit nécessaires pour passer d'une fonction transfert à une autre, et d'autre part d'utiliser une structure de circuit à motif répétitif dans laquelle seules certaines interconnexions et les surfaces d'armature supérieures de capacités varient d'un motif à l'autre, les surfaces d'armature inférieures restant identiques d'un motif à l'autre.

Plus précisément, le circuit intégré de filtrage à capacités commutées selon l'invention comporte, sur un substrat semiconducteur, un ensemble d'éléments intégrés qui sont notamment des transistors, des connexions, ainsi que des armatures inférieures et des armatures supérieures de capacités, dans lequel les éléments intégrés comprennent plusieurs motifs de circuit qui se répètent topologiquement à l'identique, chaque motif comprenant un amplificateur opérationnel, et des interrupteurs reliés principalement d'une part aux armatures supérieures ou aux armatures inférieures des capacités et d'autre part à l'entrée de l'amplificateur ou à sa sortie ou à une masse électrique, tel que décrit dans l'article E.D.N. précédemment cité. Ce circuit et principalement caractérisé en ce que:

– les motifs se répètent topologiquement à l'identique à l'exception d'un petit nombre de portions de connexions qui peuvent différer d'un motif à l'autre, ces portions de connexion étant constituées par les extrémités des capacités non commutées reliées, soit à une autre capacité non commutée, soit à une armature inférieure d'une capacité commutée, soit à une armature supérieure d'une capacité commutée et à l'exception des armatures supérieures des capacités utiles du circuit qui seront effectivement reliées à d'autres capacités, ces armatures étant des armatures de capacités non commutées ou commutées, ces armatures ayant des surfaces pouvant varier d'un motif à l'autre tandis que les armatures inférieures de ces capacités utiles sont identiques d'un motif à l'autre et ont chacune une surface en principe strictement supérieure à la surface de l'armature supérieure correspondants; et en ce que chaque motif comprend un amplificateur opérationnel, des interrupteurs reliés principalement d'une part aux armatures supérieures ou inférieures de capacités, et d'autre part à l'entrée de l'amplificateur ou à sa sortie ou à une masse électrique, et plusieurs champs de capacités définis chacun par une large armature inférieure, un premier champ ou groupe de champs étant réservé à la consitution d'une capacité de bouclage non commutée reliée directement entre la sortie et l'entrée de l'amplificateur, un deuxième champ ou groupe de champs étant réservé à la réalisation d'autres capacités non commutées reliant la sortie d'un amplificateur d'un motif à l'entrée d'un amplificateur d'un autre motif, et un troisième champ ou groupe de champs étant réservé à la réalisation de capacités commutées reliant la sortie d'un amplificateur d'un motif à l'entrée d'un amplificateur d'un autre motif ou du même; et en ce que au moins deux phases disjointes d'horloge sont prévues pour commander les différents interrupteurs, et les capacités utiles du troisième champ ou groupe de champs sont reliées chacune à au moins deux interrupteurs commandés par des phases disjointes; et en ce que un bus, ayant au moins autant de conducteurs de connexion qu'il y a de motifs de circuit répétés, court le long de ces motifs, et lessorties des amplificateurs utiles du circuit sont reliées chacune à un conducteur respectif du bus.

Certains champs de capacités sont juxtaposés de sorte qu'ils ont une armature inférieure commune; cela peut être le cas par exemple des divers champs d'un même groupe.

Les armatures supérieures de capacités sont de préférence réalisées en même temps que les portions de connexions qui diffèrent d'un motif à l'autre; ces armatures supérieures et portions de connexions sont toutes réalisées de préférence par un deuxième niveau de silicium polycristallin ou un niveau de métallisation.

Enfin, on peut prévoir que le circuit comporte deux motifs différents qui sont répétés chacun plusieurs fois, comme on l'expliquera par la suite.

D'autres caractéristiques et avantages de l'invention arraraîtront à la lecture de la description détaillée qui suit et qui est faite en référence aux dessins annexés dans lesquels:

la fig. 1, représente trois types de liaisons capacitives couramment utilisées dans des filtres à capacités commutées;

la fig. 2, représente un schéma-bloc exposant le principe de l'invention;

la fig. 3, représente concrètement une réalisation particulièrement optimisée de l'invention.

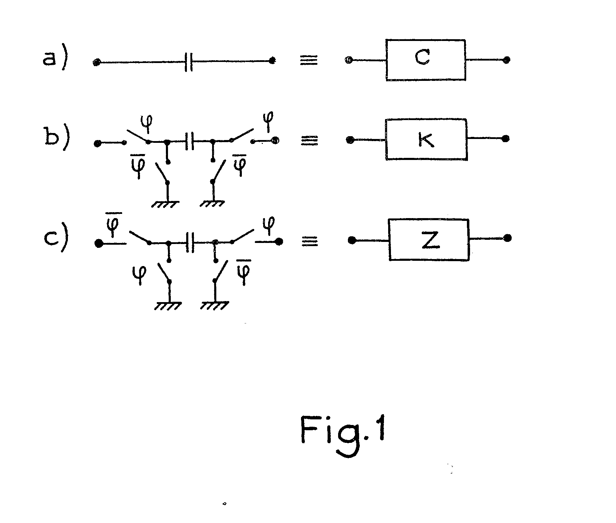

A titre de rappel préliminaire, on a indiqué sur la figure 1 trois types de montages de capacités figurant couramment dans le filtres à capacités commutées:
- à la ligne a, une capacité non commutée qu'on appellera capacité de type C, représentée par un bloc avec la lettre C,
- à la ligne B, une capacité commutée non inverseuse, n'introduisant pas de retard, qu'on appellera capacité de type K, représentée par un bloc avec la lettre K.
- à la linge c, une capacité commutée inverseuse, introduisant un retard d'une période d'échantillonnage, qu'on appellera capacité de type Z, représentée par un bloc avec la lettre Z.

Les lettres grecques figurant à côté des interrupteurs représentent deux phases disjointes de commutation pendant lesquelles les interrupteurs sont fermés ou ouverts; c'est le choix de ces phases qui détermine le type de capacité, K ou Z.

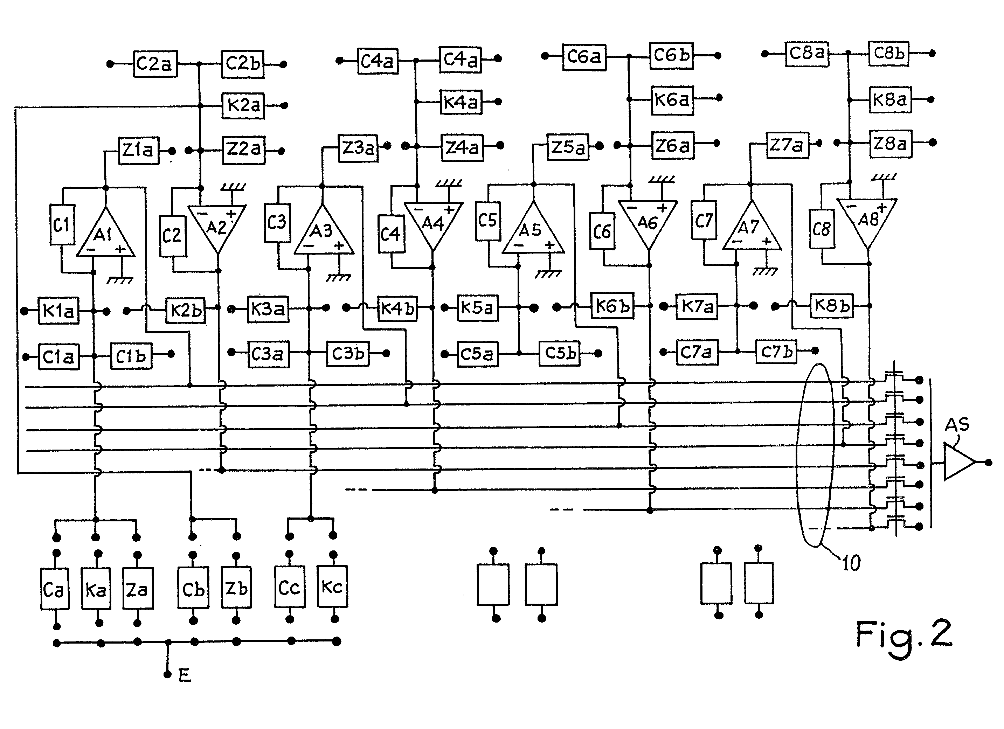

La figure 2 représente, avec les conventions correspondant à la figure 1, la structure globale du circuit selon l'invention.

On distingue sur cette figure plusieurs motifs de circuit qui se répètent à l'identique, chaque motif comprenant un amplificateur opérationnel et plusieurs capacités commutées ou non.

En réalité, on peut dire que le circuit comporte deux types de motifs: un motif qu'on appellera motif impair correspondant à un amplificateur de numéro impair (numérotation de la gauche vers la droite sur la figure), et un motif dit «motif pair» correspondant aux amplificateurs de numéro pair. Les motifs pair et impair sont donc disposés alternativement dans la série. Les motifs pairs comportent en fait une capacité commutée de plus que les motifs impairs.

Sur la figure 2, on a représenté huit motifs (quatre impairs, quatre pairs), avec des amplificateurs opérationnels respectifs A1 à A8.

Le motif impair comprend, outre l'amplificateur, une capacité non commutée reliée entre l'entrée et la sortie de l'amplificateur (C1 pour l'amplificateur A1, C3 pour l'amplificateur A3, etc.), et, reliées par une extrémité à l'entrée de l'amplificateur, plusieurs capacités, à savoir:

- deux capacités non commutées (C1a et C1b pour l'amplificateur A1, C3a et C3b pour A3, etc.), les autres extrémités de ces capacités étant représentées non raccordées car leurs connexions de raccordement peuvent justement différer d'un motif à l'autre.
- une capacité commutée de type K (K1a pour A1, K3a pour A3, etc.) dont l'autre extrémité est également représentée non raccordée.

En outre, le motif impair comprend une capacité commutée de type Z (Z1a pour A1, Z3a pour A3, etc.) dont une extrémité est reliée à la sortie de l'amplificateur et dont l'autre extrémité est représentée non raccordée.

Le motif pair comprend, outre l'amplificateur, une capacité de bouclage non commutée reliée entre l'entrée et la sortie de l'amplificateur (C2 pour A2, C4 pour A4, etc.), et, reliées par une extrémité à l'entrée de l'amplificateur, plusieurs capacités, à savoir:

- deux capacités non commutées (C2a et C2b pour l'amplificateur A2, C4a et C4b pour A4 etc.), les autres extrémités de ces capacités étant représentées non raccordées car leurs connexions de raccordement peuvent différer d'un motif à l'autre;
- une capacité commutée de type Z (Z2a pour A2, Z4a pour A4 etc.) dont l'autre extrémité est, toujours pour la même raison représentée non raccordée;
- et une capacité commutée de type K (K2a pour l'amplificateur A2, K4a pour A4 etc.).

En outre, le motif pair comprend une capacité commutée de type K (K2a pour A2, K4a pour A4 etc.) dont une extrémité est reliée à la sortie de l'amplificateur et dont l'autre extrémité est représentée non raccordée.

Le schéma de la figure 2 comprend encore un bus de connexions désigné par la référence globale 10, qui court le long des motifs et qui comprend au moins autant de conducteurs de connexion qu'il y a de motifs, à savoir huit. Chaque sortie d'amplificateur est reliée à un conducteur respectif de ce bus.

On peut prévoir par exemple que l'un, au choix, des conducteurs du bus est raccordé, par une connexion non représentée car elle dépend du choix effextué, à l'entrée d'un amplificateur de sortie AS, qui fournit le signal de sortie du filtre. On peut prévoir de plus, en série entre l'entrée de l'amplificateur et les conducteurs du bus, des transistors interrupteurs pour le choix de la phase de prélèvement du signal de sortie.

Enfin, l'entrée E du filtre peut être raccordée, au choix, par des connexions non représentées, à une ou plusieurs capacités, commutées ou non, prises parmi les suivantes:
- trois capacités Ca, Cb et Cc non commutées,
- deux capacités Ka et Kb de type K,
- deux capacités Za et Zb de type Z.

Ni l'une ni l'autre des extrémités de ces capacités commutées ne sont représentées raccordées car dans certains cas elle peuvent être utilisées non pas pour un raccordement à l'entrée E du filtre mais pour des raccordements tout à fait différents. Cependant, en principe l'entrée du filtre sera raccordée par une ou deux capacités à l'entrée du premier amplificateur opérationnel A1 et éventuellement par une capacité à l'entrée du deuxième et par une autre à l'entrée du troisième.

Enfin, d'autres capacités représentées non raccordées peuvent être prévues en plus et raccordées à divers points dans des cas très pariculiers.

A partir de ces motifs de base juxtaposés, on peut réaliser une grande quantité de circuits de filtrage en combinant les différents motifs au moyens de raccordements entre des connexions représentées non raccordées sur la figure 2.

A titre d'exemple seulement, on peut indiquer qu'on peut réaliser un filtre passe-bas d'ordre 5 (type Cauer) grâce aux raccordements suivants:

– K1a est raccordé à la sortie de A1;
– C1a à la sortie de A3 (par la connexion correspondante du bus 10);
– C1b à la masse;
– Z1a à l'entrée de A2;
– K2a, C2a, C2b à la masse;
– K2b à l'entrée de A1;
– Z2a à la sortie de A3;
– K3a à la sortie de A2;
– Z3a à l'entrée de A4;
– C3a à la sortie de A1 par le bus de connexion;
– C3b à la sortie de A5 par le bus de connexion;
– K4a, C4a, C4b à la masse;
– K4b à l'entrée de A3;
– Z4a à la sortie de A5;
– K5a à la sortie de A4;
– Z5a à l'entrée de A5;
– C5a à la masse;
– C5b à la sortie de A3;
– la sortie de A4, par l'intermédiaire de la connexion correspondante du bus 10, à l'entrée de l'amplificateur de sortie AS;
– la capacité Za entre l'entrée E et l'entrée de A1;
– la capacité Cb entre l'entrée E et l'entrée de A2;
– la capacité Kc entre l'entrée E et l'entrée de A3.
Les autres raccordements ne sont pas connectés.

Bien d'autres types de filtres peuvent être réalisés avec le schéma de la figure 2 et des connexions appropriées. Entre autres:
– filtres passe-bas type Chebychev;
– filtres passe-haut;
– filtres passe-bande symétriques;
– filtres à cascade de cellules biquadratiques, passe-bas, passe-haut, passe-bande, réjecteurs, dèphaseurs, etc.

Pour la réalisation pratique, les valeurs numériques des caractéristiques du filtre nécessitent un choix approprié des valeurs des capacités, commutées ou non, du schéma.

Par conséquent, dans la réalisation en circuit intégré, on prévoit des champs de capacités correspondant à chacun des blocs de liaison de type C, K ou Z représentés sur la figure 2; en pratique, on réserve pour chaque bloc (capacité commutée ou non) un espace suffisant pour y former une capacité dont la valeur pourra varier dans de larges limites. Cet espace est défini par l'armature inférieure de la capacité (armature par exemple constituée par un premier niveau de silicium polycristallin).

L'armature supérieure aura une surface plus petite (sauf exceptionellement si une capacité du circuit doit avoir la valeur maximale possible autorisée par la surface du champ réservé) et ne recouvrira donc qu'une partie du champ disponible. Le diélectrique entre les armatures est une couche isolante (par exemple d'oxyde de silicium) dont l'épaisseur est constante pour tous les champs de capacités de sorte que la valeur numérique d'une capacité est directement liée à la surface de son armature supérieure.

L'armature supérieure est par exemple constituée par un deuxième niveau de silicium polycristallin et les connexions de raccordement entre motifs de circuit peuvent être réalisées en même temps par ce deuxième niveau de silicium polycristallin, ou encore par un niveau de métallisation final (aluminium). Dans tous les cas, on peut attendre une étape tardive de fabrication avant de choisir le type et les caractéristiques numériques du filtre que l'on veut réaliser finalement. Un grand nombre de circuits peuvent donc subir en bloc toutes les étapes précédentes de fabrication sans qu'il y ait lieu de tenir compte dans le processus de la nature et des caractéristiques des filtres qui doivent être réalisés finalement.

Le schéma de la figure 2 est surtout un schéma de principe, mais la réalisation pratique tient compte d'un certain nombre de facteurs supplémentaires, et notamment:

1) du fait que les capacités de type Z et de type K sont en fait de même nature, seule les phases de commutation des interrupteurs étant différentes;

2) du fait que quatre interrupteurs sont nécessaires pour la réalisation d'une capacité Z ou K prise isolément, mais que, pour la réalisation de deux capacités commutées de même type connectées au même point, deux interrupteurs peuvent être utilisés en commun par les deux capacités;

3) du fait qu'une capacité destinée à relier la sortie d'un amplificateur d'un motif à l'entrée d'un amplificateur d'un autre motif peut être considérée indifféremment comme faisant partie de l'un ou l'autre des motifs: par exemple la capacité K2b de la figure 2 sera le plus souvent reliée à l'entrée du premier amplificateur et pourrait très bien être considérée comme faisant partie du premier motif et non du deuxième.

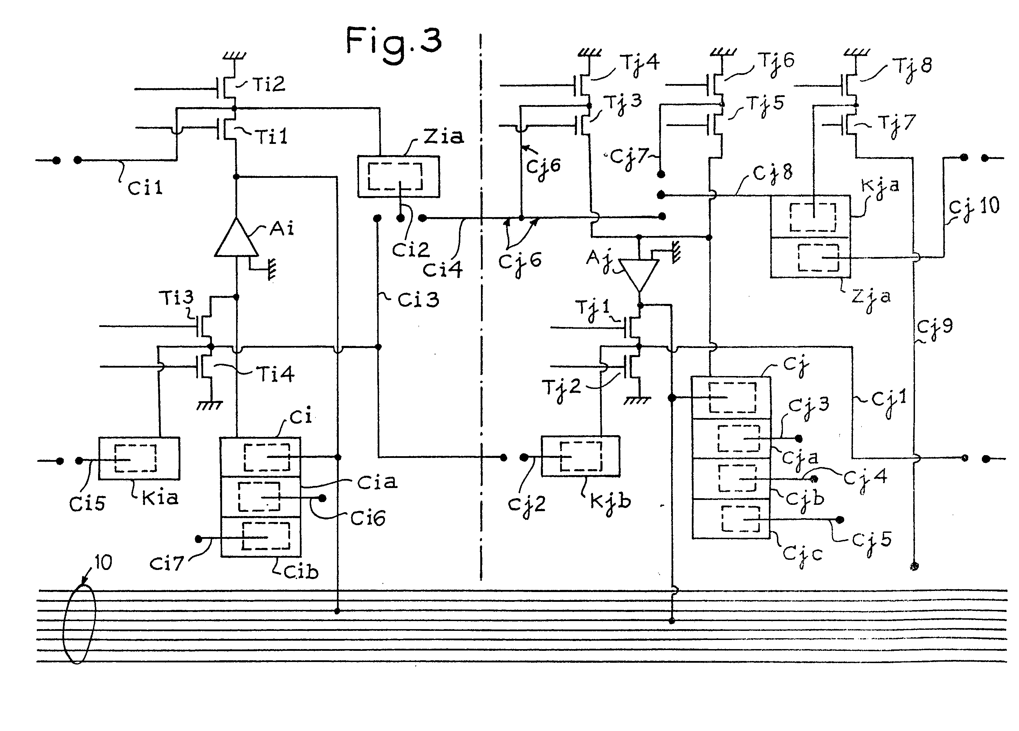

Un schéma concret, particulièrement satisfaisant, de réalisation de l'invention, est proposé à la figure 3. Deux motifs consécutifs, un motif impair et un motif pair ont été représentés, correspondent respectivement à un amplificateur Ai et un amplificateur Aj.

Le motif impair, visible sur la partie gauche de la figure 3, comprend d'abord l'amplificateur opérationnel Ai dont la sortie est reliée à un conducteur spécifique du bus 10; il comprend aussi deux interrupteurs (transistors MOS Ti1 et Ti2) en série entre cette sortie et une masse électrique, ces deux interrupteurs étant commandés par deux phases disjointes.

Le système d'élaboration des phases de commande n'est pas représenté; il est très classique dans tous les systèmes échantillonnés, et ne présente pas de difficulté de réalisation. La grille de l'un des transistors sera reliée à un conducteur amenant la première phase ou à un autre conducteur amenant la deuxième phase selon les cas.

Le point de jonction des interrupteurs Ti1 et Ti2 est relié d'une part à une portion de connexion Ci1 qui peut elle-même être reliée à une portion de connexion en provenance d'un motif pair, et d'autre part à une armature (en principe inférieure) d'une capacité d'un champ Zia dont l'armature supérieure, si elle existe, est reliée à une portion de connexion Ci2 qui elle-même peut être reliée soit à une portion de connexion Ci3, soit à une portion de connexion Ci4, toutes deux susceptibles d'être reliées au motif pair suivant (motif de rang j). On a représenté sur la figure 3 cette possibilité de connexion de Ci2 soit à Ci3 soit à Ci4.

La connexion Ci3 est reliée au point de jonction de deux interrupteurs en série, Ti3 et Ti4 commandés par des phases disjointes.

Le point de jonction des interrupteurs Ti3 et Ti4 est encore relié par ailleurs à une armature (en principe inférieure) d'une capacité d'un champ Kia dont l'armature supérieure, lorsqu'elle est utilisée, est reliée à une portion de connexion Ci5 susceptible d'être elle-même reliée notamment au motif de rang pair précédent.

Les champs de capacités Zia et Kia sont réservés à la constitution de liaisons à capacités commutées à partir de la sortie de l'amplificateur Ai (champ Zia) ou vers l'entrée de Ai (champ Kia).

Le motif impair comprend encore trois champs de capacités de type C (capacités non commutées), respectivement Ci, Cia et Cib, qui sont de préférence juxtaposés et ont alors une armature inférieure commune, reliée à l'entrée de l'amplificateur Ai.

Le champ Ci est réservé à la capacité de bouclage de l'amplificateur Ai; l'armature supérieure de la capacité correspondant à ce champ est donc reliée directement à la sortie de l'amplificateur Ai.

Le champ Cia et le champ Cib servent à l'établissement de liaisons capacitives directes vers l'entrée de l'amplificateur Ai, par exemple à partir des sorties d'amplificateurs d'autres motifs; c'est pourquoi les armatures supérieures des capacités de ces champs, lorsqu'elles sont prévues dans le circuit, peuvent être reliées, par l'intermédiaire de connexions Ci6 et Ci7 respectivement, à des conducteurs du bus 10.

Le motif pair, visible sur la partie droite de la figure 3, comprend d'abord l'amplificateur opérationnel Aj dont la sortie est reliée à un conducteur spécifique du bus 10; il comprend aussi deux interrupteurs (transistors MOS Tj1 et Tj2) commandés par des phases disjointes, en série entre cette sortie et la masse électrique.

Le point de jonction des interrupteurs Tj1 et Tj2 est relié d'une part à une portion de connexion Cj1 qui elle-même peut être reliée à une portion de connexion du motif impair suivant (l'analogue de la portion Ci5 décrite en référence au motif impair précédent) et d'autre part à une armature (en principe inférieure), d'une capacité d'un champ Kjb dont l'armature supérieure, si elle existe, est reliée à une portion de connexion Cj2 qui elle-même peut être reliée notamment à la portion de connexion Ci3 du motif impair immédiatement précédent.

Le champ de capacité Kjb est réservé normalement à la constitution d'une liaison à capacité commutée de type K (en principe) ou Z entre la sortie de l'amplificateur du motif pair et l'entrée de l'amplificateur du motif impair immédiatement précédent.

Le motif pair comprend par ailleurs au moins trois champs de capacités de type C (non commutées), qui sont de préférence juxtaposés et ont alors une armature inférieure commune, laquelle est reliée à l'entrée de l'amplificateur Aj. Sur la figure 3, quatre champs Cj, Cja, Cjb, Cjc sont prévus.

Le champ Cj est réservé à la capacité de bouclage de l'amplificateur Aj; l'armature supérieure de la capacité correspondante est donc reliée directement à la sortie de l'amplificateur Aj.

Les champs Cja, Cjb, Cjc servent à d'établissement de liaisons capacitives directes vers l'entrée de l'amplificateur Aj, par exemple à partir des sorties d'amplificateurs d'autres motifs ou de l'entrée du filtre; c'est pourquoi les armatures supérieures des capacités de ces champs, lorsqu'elles sont prévues dans le circuit, peuvent être reliées, par l'intermédiaire de connexions Cj3, Cj4, Cj5 respectivement, à des conducteurs du bus 10, ou à l'entrée du filtre.

Le motif pair comprend encore en principe trois couples d'interrupteurs en série, respectivement Tj3 et Tj4, Tj5 et Tj6, Tj7 et Tj8 et deux champs de capacités, Kja et Zja.

Les couples d'interrupteurs (transistors) Tj3 et Tj4 d'une part et Tj5 et Tj6 d'autre part sont chacun en série entre l'entrée de l'amplificateur Aj et la masse et, à l'intérieur de chaque couple, les deux transistors sont commandés par des phases disjointes à choisir en fonction du filtre à réaliser.

Le point de jonction des interrupteurs Tj3 et Tj4 est relié par une portion de connexion Cj6 à la portion de connexion Ci4 du motif impair immédiatement précédent.

Le point de jonction des interrupteurs Tj5 et Tj6 est relié à une portion de connexion Cj7.

Une portion de connexion Cj8 est prévue dans le motif pair pour relier une armature (en principe inférieure) du champ Kja soit à la connexion Cj7, soit à la connexion Cj6.

De préférence, les champs Kja et Zja sont juxtaposés et ont une armature inférieure commune.

Le champ Zja est réservé en principe à la constitution d'une liaison à capacités commutées entre la sortie de l'amplificateur du motif impair suivant et l'entrée de l'amplificateur Aj; c'est pourquoi l'armature supérieure de la capacité du champ Zja, si elle est prévue, est reliée à une portion de connexion Cj10 qui, elle-même, peut être reliée au motif impair suivant (par une connexion analogue à Ci1).

Le champ Kja est réservé en principe à la réalisation de liaisions à capacités commutée entre la sortie d'un amplificateur d'un motif pair précédant le motif pair considéré, et l'entrée de l'amplificateur Aj, notamment dans le cas de filtres à cascades d'étages biquadratiques. C'est pourquoi l'armature supérieure de la capacité du champ Kja est reliée au point de jonction de l'ensemble en série des transistors interrupteurs Tj7 et Tj8 commandés eux aussi par des phases disjointes. Le transistor Tj8 est relié à la masse; le transistor Tj7 est relié à une portion de connexion Cj9 qui elle-même peut être reliée à un conducteur du bus 10.

Sur la figure 3, on n'a représenté aucune des connexions dont la présence ou l'absence dépendent du type du schéma utilisé. Seuls sont représentés les éléments figés des motifs, c'est à dire ceux qui se répètent d'un motif à l'autre quel que soit le schéma de filtre. Une exception a été faite toutefois pour les portions de connexion issues des armatures supérieures de capacités (par exemple Ci5, Ci6, Ci7, etc.); dans la mesure où ces capacités ne sont pas utilisées dans le schéma, les portions de connexion qui y sont directement reliées peuvent disparaître complètement.

Enfin, comme on le voit sur la figure 3, les armatures supérieures des capacités ont été représentées symboliquement par des rectangles pointillés plus petits que les armatures inférieures (en traits pleins) définissant les différents champs. Les connexions parvenant aux armatures supérieures sont représentées comme pénétrant dans ces rectangles pointillés tandis que les connexions vers les armatures inférieures s'arrêtent au bord des rectangles en traits pleins définissant ces armatures inférieures.

### Revendications

1. Circuit intégré de filtrage à capacités commutées comportant, sur un substrat semiconducteur, un ensemble d'éléments intégrés qui sont notamment des transistors, des connexions, ainsi que des armatures inférieures et des armatures supérieures de capacités, dans lequel les éléments intégrés comprennent plusieurs motifs de circuit qui se répètent topologiquement à l'identique, chaque motif comprenant un amplificateur opérationnel (Ai, Aj), et des interrupteurs reliés principalement d'une part aux armatures supérieures ou aux armatures inférieures des capacités et d'autre part à l'entrée de l'amplificateur ou à sa sortie ou à une masse électrique, caractérisé en ce que:
   – les motifs se répètent topologiquement à l'identique à l'exception d'un petit nombre de portions de connexions qui peuvent différer d'un motif à l'autre ces portions de connexion étant constituées par les extrémités des capacités non commutées reliées, soit à une autre capacité non commutée (Ci2 à Ci2 ou Ci2 à Ci4; Cj8 à Cj7 ou Cj8 à Cj7; Cj6 à Cj4; Cj2 à Ci3) soit à une armature inférieure d'une capacité commutée (Ci1, à Zia; Ci3 à Kia; Cj1 à Kjb; Cj8 à Kja) soit à une armature supérieure d'une capacité commutée (Ci5 à Kia, Ci6 à Cia; Cj2 à Kjb; Cj10 à Zja) et à l'exception des armatures supérieures des capacités utiles du circuit, qui seront effectivement reliées à d'autres capacités, ces armatures étant des armatures de capacités non commutées (Ci, Cj) ou commutées (Kia, Zia, Kja, Zja), ces armatures ayant des surfaces pouvant varier d'un motif à l'autre tandis que les armatures inférieures de ces capacités utiles sont identiques d'un motif à l'autre et ont chacune une surface en principe strictement supérieure à la surface de l'armature supérieure correspondants;
   – en ce que chaque motif comprend en outre plusieurs champs de capacités définis chacun par une large armature inférieure de capacités, un premier champ ou groupe de champ (Ci, Cj) étant réservé à la réalisation d'une capacité de bouclage non commutée reliée directement entre la sortie et à l'entrée de l'amplificateur opérationnel, un deuxième champ ou groupe de champs (Cia, Cib, Cja, Cjb, Cjc) étant réservé à la réalisation d'autres capacités non commutées reliant la sortie d'un amplificateur d'un motif à l'entrée d'un amplificateur d'un autre motif, et un troisième champ ou groupe de champs (Zia, Kia, Zja, Zjb) étant réservé à la réalisation de capacités commutées reliant la sortie d'un amplificateur d'un motif à l'entrée d'un amplificateur d'un autre motif ou du même motif;
   – en ce que au moins deux phases disjointes d'horloge sont prévues pour commander les différents interrupteurs et les capacités utiles du troisième champ ou groupe de champs sont reliées chacune au point de jonction de deux interrupteurs en série commandés par des phases disjointes;
   – et en ce qu'un bus (10) ayant au moins autant de conducteurs de connexion qu'il y a de motifs de circuits, court le long de ces motifs et les sorties des amplificateurs utiles du circuit sont reliées chacune à un conducteur respectif de ce bus.

2. Circuit intégré selon la revendication 1, caractérisé en ce que des champs de capacités non commutés (Ci, Cia, Cib; Cja, Cjb, Cjc par exemple) sont juxtaposés et possèdent de ce fait une armature inférieure commune.

3. Circuit intégré selon l'une des revendications 1 ou 2, caractérisé en ce que deux motifs, «impair» et «pair», différents sont prévus, chacun se répétant plusieurs fois, et en ce que chaque motif «pair» est intercalé entre deux motifs «impairs» et réciproquement.

4. Circuit intégré selon l'une des revendications 1 à 3, caractérisé en ce que chaque motif comporte au moins un couple d'interrupteurs (Ti1, Ti2) actionnés par deux phases de commutation disjointes, en série entre la sortie de l'amplificateur (Ai) et la masse, le point de jonction de ces interrupteurs étant relié à une armature d'un champ de capacités (Zia) réservé à la réalisation d'une Maison à capacités commutée, et au moins un autre couple d'interrupteurs (Ti3, Ti4) actionnés par les deux phases de commutation disjointes, en série entre l'entrée de l'amplificateur et la masse, le point de jonction de ces interrupteurs étant relié à une armature d'un champ de capacités (Kia) réservé à la réalisation d'une liaison à capacité commutée.

5. Circuit intégré selon l'une des revendications 1 à 4, caractérisé en ce que les portions de connexion qui diffèrent d'un motif à l'autre ainsi que les armatures supérieures de capacités sont réalisées par un deuxième niveau de silicium polycristallin ou niveau de métallisation.

**Patentansprüche**

1. Integrierter Filterkreis mit geschalteten Kondensatoren, welcher auf einem Halbleitersubstrat eine Anzahl integrierter Schaltelemente wie insbesondere Transistoren, Schaltungsverbindungen sowie untere und obere Kondensatorbeläge aufweist, wobei die integrierten Elemente mehrere Schaltungsmotive umfassen, die sich topologisch identisch wiederholen, wobei jedes Motiv einen Operationsverstärker (Ai, Aj) und Schalter aufweist, welche im wesentlichen zum einen an die oberen oder unteren Kondensatorbeläge, zum anderen an den Eingang des Verstärkers oder an eine elektrische Masse angeschlossen sind, dadurch gekennzeichnet:
– dass sich die Schaltungselemente topologisch identisch mit Ausnahme einer kleinen Anzahl von Verbindungsstücken wiederholen, die von einem Motiv zum anderen unterschiedlich sein können, wobei die Verbindungsstücke aus den Enden der nichtgeschalteten Kondensatoren gebildet sind, welche entweder mit einem anderen nichtgeschalteten Kondensator (Ci2 an Ci2 oder Ci2 an Ci4; Cj8 an Cj7 oder Cj8 an Cj7; Cj6 an Cj4; Cj2 an Ci3) oder mit einem unteren Belag eines geschalteten Kondensators (Ci1 an Zia; Ci3 an Kia; Cj1 an Kjb; Cj8 an Kja) oder mit einem oberen Belag eines geschalteten Kondensators (Ci5 an Kia; Ci6 an Cia; Cj2 an Kjb; Cj10 an Zja) verbunden sind, mit Ausnahme der oberen Beläge der Nutzkondensatoren des Filterkreises, welche effektiv zum Anschluss an andere Kondensatoren dienen, wobei diese Beläge solche von nichtgeschalteten (Ci, Cj) oder von geschalteten (Kia, Zia, Kja, Zja) Kondensatoren sind und Oberflächen besitzen, welche von Schaltungsmotiv zu Schaltungsmotiv variieren können, während die unteren Beläge dieser Nutzkondensatoren von einem Motiv zum anderen identisch sind und Oberflächen besitzen, die im Prinzip strikt grösser als die Oberflächen der zugehörigen oberen Beläge sind;
– das jedes Schaltungsmotiv weiter mehrere Kondensatorfelder umfasst, von denen jedes durch einen grossen unteren Kondensatorbelag definiert ist, wobei ein erstes Feld bzw. Feldergruppe (Ci, Cj) der Realisierung eines nichtgeschalteten Ruckkopplungskondensators vorbehalten ist, welcher direkt zwischen den Ausgang und den Eingang des Operationsverstärkers geschaltet ist; wobei ein zweites Feld bzw. Feldergruppe (Cia, Cib, Cja, Cjb, Cjc) der Realisierung anderer nichtgeschalteter Kondensatoren vorbehalten ist, welche den Ausgang eines Verstärkers eines Schaltungsmotivs mit dem Eingang des Verstärkers eines anderen Schaltungsmotivs verbinden; und wobei ein drittes Feld bzw. Feldergruppe (Zia, Kia, Zja, Zjb) der Realisierung geschalteter Kondensatoren vorbehalten ist, welche den Ausgang des Verstärkers eines Schaltungsmotivs mit dem Eingang eines Verstärkers eines anderen oder desselben Schaltungsmotivs verbinden;
– dass mindestens zwei unverbundene Taktphasen zur Steuerung der verschiedenen Schalter vorgesehen sind und jeder der Nutzkondensatoren des dritten Feldes bzw.Feldergruppe mit dem Verbindungspunkt der beiden in Reihe geschalteten Schalter verbunden ist, welche von den unverbundenen Phasen gesteuert werden; und
– dass eine Schiene (10) mit mindestens soviel Verbindungsleitern, wie Schaltungsmotive vorhanden, entlang dieser Motive geführt ist, und jeder der Ausgänge der Nutzverstärker des Filterkreises an einen entsprechenden Leiter dieser Schiene angeschlossen ist.

2. Integrierter Schaltkreis nach Anspruch 1, dadurch gekennzeichnet, dass die Felder der nichtgeschalteten Kondensatoren (Ci, Cia, Cib; Cja, Cjb, Cjc beispielsweise) einander benachbart sind und deshalb einen gemeinsamen unteren Belag besitzen.

3. Integrierter Schaltkreis nach den Ansprüchen 1 oder 2, dadurch gekennzeichnet, dass zwei verschiedene Schaltkreismotive, «ungeradzahlig» und «geradzahlig», vorgesehen sind, von denen sich jedes mehrmals wiederholt, und dass jedes geradzahlige Motiv zwischen zwei ungeradzahlige Motive eingefügt ist, und umgekehrt.

4. Integrierter Schaltkreis nach einem der Ansprüche 1 bis 3, dadurch gekennzeichnet, dass jedes Schaltungsmotiv mindestens ein Paar Schalter (Ti1, Ti2) enthält, welche von zwei unverbundenen Schaltphasen betätigt werden und in Reihe zwischen dem Ausgang des Verstärkers (Ai) und Masse liegen, wobei der Verbindungspunkt dieser Schalter mit einem Belag eines Kondensatorfeldes (Zia) verbunden ist, welches der Realisierung einer geschalteten Kondensatorverbindung vorbehalten ist, und dass mindestens ein weiteres Paar von Schaltern (Ti3, Ti4) vorhanden ist, welche von zwei unverbundenen Schaltphasen betätigt werden und in Reihe zwischen dem Eingang des Verstärkers und Masse liegen, wobei der Verbindungspunkt dieser Schalter mit einem Belag eines Kondensatorfeldes (Kia) verbunden ist, dass der Realisierung einer geschalteten Kondensatorverbindung vorbehalten ist.

5. Integrierter Schaltkreis nach einem der Ansprüche 1 bis 4, dadurch gekennzeichnet, dass die von einem Schaltungsmotiv zum anderen variierenden Verbindungsstücke sowie die oberen Beläge der Kondensatoren durch eine zweite Lage aus polykristallinem Silizium oder eine Metallisierungslage gebildet sind.

# Claims

1. An integrated filter circuit equipped with switched capacitors consisting, on a semiconductor substrate, of a certain number of integrated elements like especially transistors, connections, and lower and upper capacitor armatures, wherein the integrated elements comprise several circuit motives identically repeating themselves topologically, and each motive comprising an operation amplifier (Ai, Aj) and interrupters principally connected on the one hand with the upper or lower armatures of the capacitors and on the other hand with the input of the amplifier or with the input of it or with the ground, characterized in that:

– the circuit motives identically repeat themselves with the exception of a small number of connection portions which may differ from one motive to the other, the portions being constituted of the ends of the non-switched capacitors connected either to an other non-switched capacitor (Ci2 to Ci2 or Ci2 to Ci4; Cj8 to Cj7 or Cj8 to Cj7; Cj6 to Cj4; Cj2 to Cj3), or to a lower armature of switched capacitor (Ci1 to Zia; Ci3 to Kia; Cj1 to Kjb; Cj8 to Kja), or to an upper armature of a switched capacitor (Ci5 to Kia; Ci6 to Cia; Cj2 to Kjb; Cj10 to Zia) and which, except for the upper armatures of the load capacitors of the filter circuit, will effectively be connected to other capacitors, these armatures being armatures of the non-switched capacitors (Ci, Cj) or of the switched ones (Kia, Zia, Kja, Zja) and having surfaces that may vary from one circuit motive to the other whereas the lower armatures of the load capacitors are identical from one motive to the other, each of them having a surface in principle strictly greater than the surface of the corresponding upper armature;
– each circuit motive comprises further several capacitor fields, and that each of them is defined by a large lower armature, a first field or group of fields (Ci, Cj) being reserved for realizing a non-switched feedback capacitor interconnected between the output and the input of the operational amplifer; a second field or group of fields (Cia, Cib, Cja, Cjc) being reserved for realizing other non-switched capacitors connecting the output of an amplifier in a motive to the input of an amplifier in an other motive; and a third field or group of fields (Zia, Kia, Zja, Zjb) being reserved for realizing switched capacitors connecting the output of an amplifier in a motive with the output of an amplifier in an other motive or in the same motive;
– at least two dissociated clock phases are provided for controlling the various interrupters, and the load capacitors of the third field or group of fields are connected to the interconnection point of the two interrupters in series controlled by the dissociated phases; and
– that a bus (10) having as many conductors for connecting as there are circuit motives extends along the motives, and that the outputs of each of the load amplifiers of the filter circuit are connected to a corresponding conductor of the bus.

2. An integrated circuit according to claim 1, characterized in that the non-switched capacitor fields (Ci, Cia, Cb; Cja, Cjb, Cjc for instance) are in juxtaposition and having therefore a common lower armature.

3. An integrated circuit according to claims 1 or 2, characterized in that two different circuit motives, «even-numbered» or «uneven-numbered» are foreseen, each of which repeating itself several times, and that each even-numbered motive is inserted between two uneven-numbered motives, and vice-versa.

4. An integrated circuit according to the claims 1 to 3, characterized in that each circuit motive comprises at least one couple of interrupters (Ti1, Ti2) actuated by two dissociated switching phases and interconnected between the output of the amplifier (Ai) and the ground, the interconnection point of the interrupters being connected to an armature of a field of capacitors (Zia) reserved for realizing a connection of switched capacitors, and that at least a further couple of interrupters (Ti3, Ti4) is provided, actuated by the two dissociated switching phases and interconnected in series between the input of the amplifier and the ground, wherein the interconnection point of these interrupters is connected to an armature of a field of capacitors (Kia) reserved for realizing a connection of switched capacitors.

5. An integrated circuit according to one of the claims 1 to 4, characterized in that the connection portions differing from one motive to the other as well as the upper armatures of the capacitors are implemented by a second layer of polycristalline silicon or by a metallisation layer.

Fig.1

Fig.2

Fig.3